# EUROPEAN PATENT APPLICATION

(11) **EP 1 655 808 A1**
(43) Date of publication of application: **10.05.2006**
(21) Application number: 05077534.5
(22) Date of filing: 04.11.2005
(51) Int. Cl.: H01R 13/24

(54) **Contactor, frame comprising such a contactor, electrical measuring and testing apparatus and method of contacting by means of such a contactor**

(30) Priority: 09.11.2004 NL 1027450
(71) Applicant: Shin-Etsu Polymer Europe B.V., 5928 NS Venlo (NL)
(72) Inventor: Beurskens, Jacobus Johannes Marie, 5768 GG Meijel (NL)
(74) Representative: Dohmen, Johannes Maria Gerardus

(57) **Abstract**

A contactor (30) comprising a first (31) and a second plate-shaped body (32) of a compressible, electrically insulating material, with wirelike electrical conductors (8) extending between opposed plate surfaces (33,34;35,36) in said electrically insulating material at an angle to a normal (n) to the plate surfaces (33,34;35,36). The conductors (8) terminate in or extend some distance beyond the plate surfaces (33,34;35,36) with their ends (4,6). The first (31) and the second body (32) are arranged adjacently to each other with one of their plate surfaces (34;36), such that the ends (6) of the wirelike conductors (8) at the plate surfaces (34;36) that face towards each other are aligned in the direction of the normal (n) to the plate surfaces (33, 34; 35, 36) as much as possible, and the ends (4) of the wirelike conductors (8) at the plate surfaces that face away from each other (33;35) are aligned in the direction of the normal (n) to the plate surfaces (33,34;35,36) as much as possible. A plate-shaped third body (39) of an electrically insulating material is positioned between the adjacent plate surfaces (34;36) of the first (31) and the second body (32), which third body (39) is provided with an identical pattern of electrically conductive contact pads (42,43) on the opposed plate surfaces (40,41) thereof, wherein corresponding contact pads (42,43) on the opposed plate surfaces (40,41) aligned in the direction of the normal (n) to the plate surfaces (40,41) are electrically interconnected (44).

## Description

The invention relates to a contactor comprising a first plate-shaped body of a compressible, electrically insulating material, with wirelike electrical conductors extending between opposed plate surfaces in the electrically insulating material at an angle to a normal to the plate surfaces, which conductors terminate in or extend some distance beyond the plate surfaces with their ends.

Contactors of this type are known per se in practice, such as a contactor or interconnector of the type MT or MT-4X commercially available from applicant.

In practice these contactors are used for electrically contacting terminals of electronic components or electronic modules and/or electric wiring at one end of one or more of the wirelike conductors, and for connecting measuring and testing means of a measuring and testing apparatus at the other end of the conductors. Such as, for example, for testing and/or measuring of the operation of a relevant component, module or wiring during the product development phase, and for testing end products, called "back-end testing" in English professional literature.

The technology that is still widely used for this purpose makes use of electrical contact pins, also known by the name of "pogo pin" in English professional literature, which are arranged in a pattern corresponding to the pattern of electrical terminals of an electronic component and/or a wiring to be measured or tested. In use, the contact pins in question are mechanically pressed against the terminals of the component or the wiring under a spring load.

Due to the strong miniaturisation of electronic components, the dimensions of the contact pins themselves and the spacing between the contact pins must be increasingly reduced. These smaller dimensions and the smaller tolerances this involves make the production of a frame comprising a pattern of contact pins specifically geared to a component or a wiring to be tested not only relatively costly, but in addition such a frame is very susceptible to failure.

It will be understood that if one or more of the contact pins does not make (sufficient) contact with a terminal of a component or a wiring to be tested or measured, for example due to fouling, wear or otherwise, the test or the measurement will lead to incorrect results, in which case it is uncertain whether this is caused by a defective component or wiring or by a faulty contact via the frame of contact pins. In the case of automated measurements or tests of large numbers of components, very high mechanical requirements are set to the frames comprising spring-loaded contact pins, in particular when measurements or tests must be carried out at high and relatively low temperatures in order to ascertain whether the component in question adequately functions within a specified temperature range.

Another risk involved in the use of contact pins is the possibility of damage being caused to the terminals of the components or wiring to be tested, which may directly or in the long run lead to incorrect functioning of the component or the wiring in question.

The above drawbacks are avoided by using a contactor as referred to in the introduction. These contactors can be provided with a sufficient number of thin electrical conductors for contacting most miniaturised components or wiring. Furthermore, such a contactor has superior electrical properties in comparison with a pattern of contact pins, for example for measuring and/or testing radio frequency (RF) components without any risk of terminals being damaged.

Since the wirelike electrical conductors extend obliquely, i.e. at an angle to the normal to the plate surfaces, in the electrically insulating material of the first plate-shaped body of the contactor, the ends of an electrical conductor located on opposite plate surfaces are displaced relative to each other. That is, a certain offset is present between the ends of a conductor in the direction parallel to the plate surfaces. This offset presents a problem when the known contactor is used in measuring and testing apparatus designed for contacting components or wiring by means of contact pins. The reason for this is the following.

The contact pins, which have a straight, elongated shape, are connected to a measuring and analysing apparatus at the ends that are not in contact with the terminals of the component or the wiring. This connection takes place via a pattern of terminal pads and conductor tracks on a printed circuit board, which pattern at least partially corresponds to the pattern of the terminals of the component, module or wiring that is to be measured or tested. As already indicated above, the tolerances are very small, in particular in the case of miniaturised components or wiring, so that the pattern of terminal pads on the printed circuit board must be precisely aligned with the pattern of contact pins. To that end, suitable alignment provisions have been made in the measuring and testing apparatuses that are used in practice. Due to the offset in the known plate-shaped contactors of the type referred to in the introduction, it is not possible to use these plate-shaped contactors without adapting the known measuring and testing apparatuses. Adapting the measuring and testing apparatuses that are already being used in practice requires a costly and time-consuming investment.

Accordingly, it is a first object of the invention to provide a novel contactor of the type referred to in the introduction which can be used in existing measuring and testing apparatuses equipped for the use of contact pins for electronic components and/or wiring, whilst retaining its advantageous electrical properties.

Another object of the invention is to facilitate the use of such contactors specifically geared to particular components and/or wiring.

Yet another object of the present invention is to provide a measuring and testing apparatus provided with such a contactor.

The invention also provides a method for electrically contacting terminals of electric components and wiring by means of such a contactor.

The invention provides a contactor of the kind referred to in the introduction, which is further characterized by a second plate-shaped body of a design similar to that of the first plate-shaped body, which first and second bodies are arranged adjacently to each other with one of their plate surfaces, such that the ends of the wirelike conductors at the plate surfaces that face towards each other are aligned in the direction of the normal to the plate surfaces as much as possible, and the ends of the wirelike conductors at the plate surfaces that face away from each other are aligned in the direction of the normal to the plate surfaces as much as possible, wherein a plate-shaped third body of an electrically insulating material is positioned between the adjacent plate surfaces of the first and the second body, which third body is provided with an identical pattern of electrically conductive contact pads on the opposed plate surfaces thereof, wherein corresponding contact pads on the opposed plate surfaces aligned in the direction of the normal to the plate surfaces are electrically interconnected.

The invention is based on the perception that the offset between the ends of a wirelike conductor can be compensated by positioning the second plate-shaped body adjacently to the first plate-shaped body, in mirror-opposite relationship therewith, as it were. That is, in such a manner that the ends of wirelike conductors at the inner plate surfaces facing towards each other are aligned in the direction of the normal to the plate surfaces as much as possible, and that the ends of the wirelike conductors at the outer plate surfaces facing away from each other of the combination of two plate-shaped bodies formed in this manner are aligned in the direction of the normal to the plate surfaces as much as possible. An interconnection between the wirelike conductors of the adjacent first and second plate-shaped bodies is effected by means of the plate-shaped third body in accordance with the pattern of the contact pads on the third plate-shaped body and without any significant offset between the ends of the conductors at the outer plate surfaces of the contactor that face away from each other.

The contactor according to the invention can be used for replacing the prior art frames comprising contactors provided with contact pins without alterations to the measuring and testing apparatuses designed for this purpose being required for aligning the component and the connections to the measuring and testing means of the measuring and testing apparatus.

The existing measuring and testing apparatuses can now be fitted with a contactor according to the invention in a simple manner, without any constructional adaptations being required, whilst retaining all the advantages of the use of this type of contactors in comparison with connectors provided with contact pins, as already explained in the foregoing.

The first, second and third plate-shaped bodies can be mounted fixedly together in the form of an assembly or be arranged on top of or above each other as separate components, and be moved into contact with each other and with the terminals of a component or wiring to be measured or tested and, for example, terminal pads of measuring and testing means, in use by exerting a mechanical force in the direction of the normal to the plate surfaces.

The third plate-shaped body may be provided with a specific pattern of contact pads that corresponds to the pattern of the electrical terminals of an electric component or wiring to be tested or measured. The first and the second plate-shaped body may be of a universal design, comprising a large number of wirelike conductors that may extend in a plate-shaped body without being arranged in a specific pattern or in a specific grid so as to obtain a maximum and reliable electrical contact with the contact pads of the third plate-shaped body and the terminals and terminal pads of components and wiring. The first, second and third bodies need not be mutually aligned in that case.

By gearing the pattern of contact pads of the third plate-shaped body to the terminals of the component or wiring in question or to the terminals of a respective component or wiring to which the measuring and testing means are to be connected, the risk of contacts and interconnections undesirably being made for measuring and testing purposes is effectively prevented.

The first and second plate-shaped bodies of a compressible, electrically insulating material, which form part of the contactor according to the invention, can be optimally arranged for contacting components having flat terminals, also known by the acronym LGA ("Land Grid Array") in practice, or semi-spherical terminals, also known by the acronym BGA ( "Ball Grid Array") or TFBGA ("Thin profile Fine pitch Ball Grid Array").

In order to make it possible to use these plate-shaped bodies comprising contact pads as known in practice, i.e. the first and the second plate-shaped body in the contactor according to the invention, the contact pads of the third body are flat in specific embodiments of the invention, or at least one plate surface of the third plate-shaped body is provided with contact pads that are embossed thereon, for example semi-spherical contact pads, in particular contact pads having the so-called BGA-profile or the FTBGA-profile. The use of the latter contact pads enables a better distribution of forces and electrical contacting of the terminal pads by the ends of the wirelike conductors of the first and/or the second plate-shaped body.

To minimise the ohmic losses in the contactor according to the invention, the contact pads and the conductors of the third body are made of gold or a gold-containing metal alloy. Preferably, the contactor according to the invention is also provided with first and second plate-shaped bodies comprising wirelike electrical conductors made of gold or a gold-containing metal alloy.

In another embodiment of the invention, the third body is made of a ceramic material, in particular for RF applications. This material optimally combines electrical and mechanical properties suitable for using the invention.

The invention also provides a frame comprising a contactor as discussed in the foregoing, which frame is provided with aligning means for aligning at least the third plate-shaped body of the contactor according to the invention in the frame.

Assuming that the contactor and the frame are elongated in shape, a simple but efficient alignment can be obtained by forming corresponding corners of the frame and the contactor, i.e. at least the third plate-shaped body thereof, with a bevel. Of course other, similarly advantageous aligning provisions likewise suitable for this purpose can be made by those skilled in the art.

To achieve an enhanced measuring and testing production, the invention provides a frame comprising a number of contactors according to the invention for measuring and testing a number of electric components or wiring simultaneously.

The contactor according to the invention, i.e. at least the third plate-shaped body thereof, is preferably secured in the frame by means of an elastic glue, such that the varying mechanical loads that are exerted on the frame and the contactor in use can be absorbed by the elastic glue, as can the differences in expansion between the contactor and the frame that occur when tests are carried out at varying high and/or low temperatures. Preferably, the frame is to that end made of a glass fibre reinforced plastic material. Advantageously, a plastic material having a low coefficient of thermal expansion is selected for that purpose, a property of the material being the fact that little static electricity, if any, is generated as a result of friction between the components to be tested, the surrounding air and the plastic material itself so as to prevent a component to be tested from being damaged by static electricity as much as possible.

It will be understood that different frames may be provided for testing mutually different components provided with different terminal patterns, using contactors in which the pattern of contact pads on the third body is geared to the component or components in question.

Such a frame can readily be placed in an electrical measuring and testing apparatus for measuring and testing electric components and wiring, making it possible to carry out measurements and tests on a number of components in a quick, simple and inexpensive manner. It will be understood that by providing a frame comprising a number of contactors according to the invention for measuring and testing a number of electric components and wiring simultaneously, the contactors in question may differ from each other, for example, each may comprise a third body provided with a pattern of contact pads geared to a specific component to be measured or tested.

The invention also provides an electric measuring and testing apparatus for measuring and testing electric components and wiring, comprising a frame as described in the foregoing.

The invention furthermore provides a method for electrically contacting terminals of electric components and wiring by means of a contactor or a frame-mounted contactor as disclosed in the foregoing, which method is characterized by the steps of:
- selecting a contactor such that the pattern of contact pads of the contactor corresponds entirely or partially to a pattern of terminals of the component or wiring to be contacted,
- aligning the contactor and the component or wiring in question relative to each other in such a manner that the corresponding contact pads and terminals are aligned, and
- contacting a respective component or wiring in the aligned position by effecting an electrical contact between the contact pads and the terminals via the ends of the wirelike conductors at a plate surface of the contactor by exerting a mechanical pressure in the direction of the normal to the plate surfaces of the contactor.

The method as described above can be used in combination with the electrical measuring or testing of a component by means of an electrical measuring and testing apparatus as described in the foregoing.

Figure 1 schematically shows a top plan view of a plate surface of a plate-shaped contactor as known from the prior art.

Figure 2 schematically shows a sectional view along the line II-II of the prior art contactor that is shown in figure 1.

Figure 3 schematically shows a view of two prior art embodiments of a so-called "pogo pin" for use in a measuring and testing apparatus for measuring and/or testing electric components and wiring.

Figure 4 schematically shows a frame, a component to be tested and a prior art contactor comprising a number of contact pins as shown in figure 3.

Figure 5 schematically shows a larger-scale sectional view of a detail of figure 4.

Figure 6 schematically shows a sectional view along the line VI-VI in figure 7 of an embodiment of the invention, which comprises a first and a second plate-shaped body with a third plate-shaped body arranged therebetween.

Figure 7 schematically shows a sectional view along the line VII-VII in figure 6 of a plate surface of the third plate-shaped body.

Figure 8 schematically shows an exploded sectional view of another embodiment of the contactor according to the invention, in which the contact pads on a plate surface have a semi-spherical profile.

Figure 9 schematically shows an exploded sectional view of yet another embodiment of the contactor according to the invention, in which the contact pads on both sides of the third body have a semi-spherical profile.

Figure 10 schematically shows an exploded view of a contactor according to the invention in combination with a frame, a connecting block for connecting testing means, and a component to be tested, which is mounted on a test plate.

Figure 11 schematically shows a sectional view of a contactor as shown in figure 6, which is mounted in a frame.

Figure 12 schematically shows a top plan view of various contactors mounted in a frame according to the invention.

Figure 13 schematically shows a top plan view of a contactor according to the invention, which is provided with a bevelled corner for alignment purposes.

Figure 14 schematically shows a partially sectional view of a contactor according to the invention, which is mounted in a further frame.

Parts that are indicated by the same numerals in the description below and in the drawings have corresponding functions.

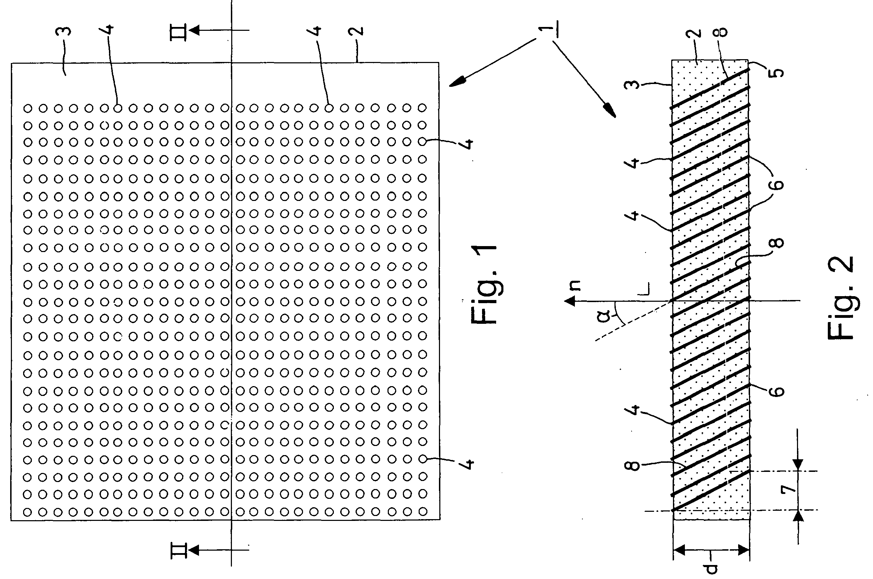

Figure 1 is a top plan view of a contactor 1 as known from the prior art in the form of a plate-shaped, flexible, flat body 2 of a compressible, electrically insulating material, such as silicone rubber or another elastomeric material.

As is clearly shown in figure 2 by the sectional view along the line II-II in figure 1, wirelike electrical conductors 8 extend in the plate-shaped body 2 from the plate surface 3 to the opposite plate surface 5 of the body 2. The wirelike electrical conductors 8 are arranged at an angle α relative to the normal n to the plate surfaces 3, 5 in the electrically insulating material. The electrical conductors 8 terminate at a plate surface 3, 5 with their respective ends 4, 6 or extend outwards some distance beyond the plate surfaces 3, 5. Since the electrical conductors 8 extend at an angle in the plate-shaped body 2, the end 6 is offset by a distance 7 in the direction parallel to a plate surface relative to the end 4 of a conductor 8.

Since the wirelike conductors 8 extend at an angle relative to the normal n to the plate surfaces 3, 5, they will not be removed from the body or be damaged upon compression of the body 1, which might be the case if the wirelike conductors 8 would extend parallel to the direction of the normal n.

A contactor of this type is commercially available from applicant as a series of contactors or interconnectors under the names of MT, MT-4X, amongst other names, for example for electrically contacting terminals of electric components, such as integrated circuits (IC's) and/or terminal pads on printed circuit boards for mounting electronic or electric components and modules thereon. The length and width dimensions of these connectors can vary from a few mm to a few dozen mm, the thickness being in the order of, for example, 0.5 mm. The offset 7 between the ends 4, 6 depends on the angle α at which the wire like conductors 8 extend in the material of the body 1, of course. In practice the offset may be 0.25-1mm. Preferably, the wirelike conductors are made of gold or a gold-containing metal alloy, extending in a non-regular pattern in the body 2 so as to effect a guaranteed and reliable contact with the terminal pads and terminals.

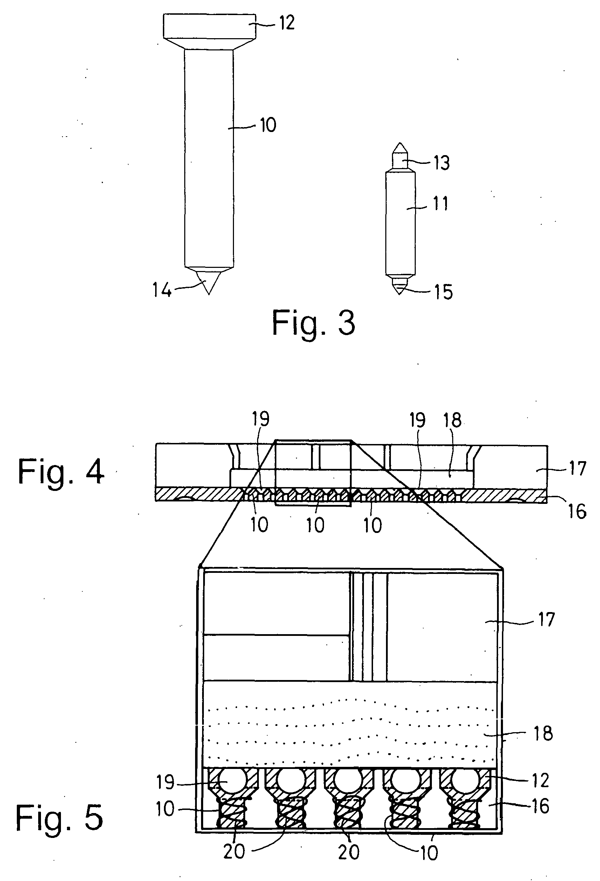

Figure 3 is a view of two prior art contact pins for use in a contactor for measuring and/or testing electric components and wiring. In English professional literature the contact pins are also referred to as "pogo pins". The contact pin indicated at 10 is a standard pin for low frequency (LF) applications, in particular up to a few kHz. The contact pin indicated at 11 is especially intended for radio frequency (RF) applications. The two contact pins 10, 11 are provided with respective contact ends 12, 13 at one end for contacting a terminal of a component or wiring to be measured or tested. At the opposite end the contact pins 10, 11 are provided with respective contact points 14, 15 for contacting a connecting block provided with circuitry or conductor tracks to measuring and testing means of a measuring and testing apparatus. In this embodiment, the contact end 12 of the contact pin 10 is configured to receive a semi-spherical terminal of a component comprising terminals which, as a whole, are referred to as a "Ball Grid Array" (BGA) in English professional literature.

Figure 4 shows the use of these contact pins, in particular the contact pin 10 of figure 3, in which a number of contact pins 10 are mounted in a body of an electrically insulating material, forming a contactor 16 accommodated in a frame 17, in which a component 18 to be tested is mounted. The contact pins 10 of the contactor 16 are aligned with the terminals 19 of the component 18, as is shown in the larger-scale, sectional view of figure 5.

Figure 5 clearly shows that the terminals 19 of the component 18 to be tested have a BGA configuration.

Figure 5 furthermore shows that the terminals 19 are entirely or partially received in the contact end 12 of the contact pins 10. Figure 5 also shows that the contact pins 10 engage the terminals 19 of the component 18 to be tested under the spring load of one or more coil springs 20.

It will be understood that if one or more of the contact pins 10 do(es) not make contact with a terminal 19, an error will occur in the measurement, in which case it is not clear whether this is caused by a defective component 18 or by a poor or faulty contact with one of the terminals 19. The contact pins 10 are not suitable for miniaturisation purposes, of course, in which case the contact pins 11 must be used, for example, which comprise a contact point 13 for contacting the terminals 19 of the component 18 to be tested. It will be understood that such a reduction of the dimensions makes additional demands on the electrical and mechanical design of the contactor, which makes the contactor relatively costly and susceptible to failure.

In practice the connection to the measuring and testing means takes place by means of a connecting block (not shown) provided with a pattern of terminal pads which is aligned with the pattern of terminals 19 of the component 18 to be measured or tested, such that the terminal pads of the connecting block contact the ends 14 or 15 of the contact pins 10 or 11. To ensure a correct contact, alignment measures have been taken so as to achieve an exact alignment of the connection block and the contact pins in the contactor relative to each other and to the component to be measured or tested.

When the contactor 16 is exchanged for the contactor 1 as shown in figures 1 and 2, it will be understood that as a result of the offset 7 the connecting block for connection to the measuring and testing means will have to be moved relative to the frame 17 by a distance corresponding to the offset 7 which, on account of the alignment measures, will involve an adaptation of the measuring and testing apparatus in practice.

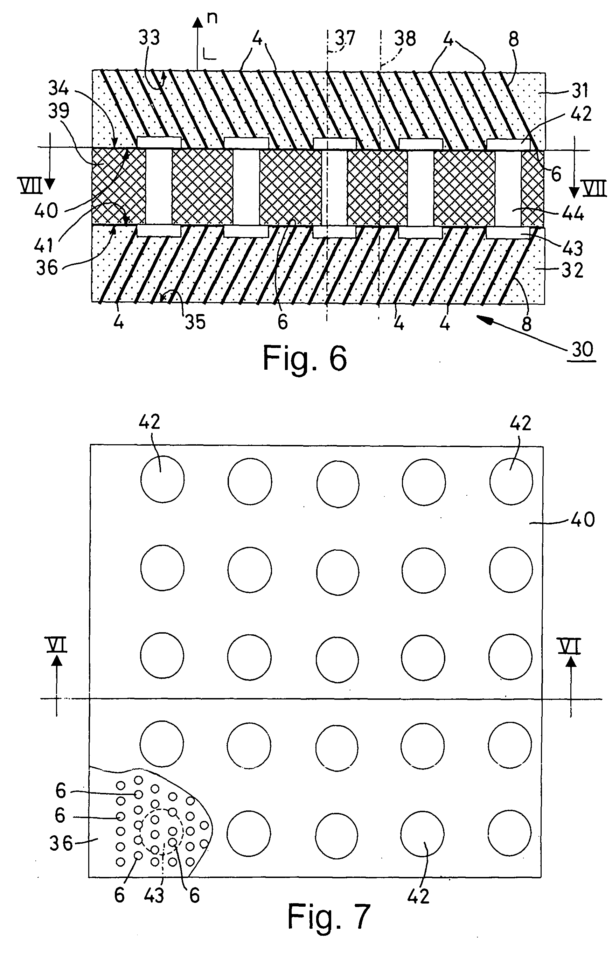

To obviate the need for such an undesirable adaptation, the invention, in a first embodiment thereof, provides a contactor 30 as schematically shown in figure 6.

In its simplest embodiment, the contactor 30 according to the invention comprises two plate-shaped bodies 31, 32 of a design similar to that of the plate-shaped body 2 that is shown in figure 1, which comprise opposed plate surfaces 33, 34 and 35, 36, respectively, and a third plate-shaped body 39 arranged between the first plate-shaped body 31 and the second plate-shaped body 32, all this in such a manner that the plate surfaces 33, 34, 35, 36, 40, 41 extend parallel to each other.

The third plate-shaped body 39 is made of an electrically insulating material and is provided with contact pads 42, 43 at its opposed plate surfaces 40 and 41, respectively. The contact pads 42, 43 are arranged according to the same pattern, and the opposed contact pads 42, 43 are connected by means of interconnections 41 extending through the thickness of the third plate-shaped body 39.

The first, second and third plate-shaped bodies 31, 32 and 39 are in mechanical contact with each other, such that the contact pads 42 of the third plate-shaped body 39 are in electrical contact with the opposed ends 6 of wirelike conductors 8 of the first plate-shaped body 31, and that the contact pads 43 of the third plate-shaped body 39 are in electrical contact with the opposed ends 6 of the wirelike electrical conductors 8 of the second plate-shaped body 32.

The first and the second plate-shaped body 31, 32 are positioned in mirror-opposite relationship with their respective plate surfaces 34, 36, such that the ends 6 of the wirelike conductors are aligned with the normal n to the plate surfaces as much as possible, as indicated by a chain-dotted line 38 on the facing inner plate surfaces 34, 36, and that the ends 4 of the wirelike conductors 8 are likewise aligned on the outer plate surfaces 33, 35 facing away from each other as much as possible, as indicated by a chain-dotted line 37. Preferably, the wirelike conductors 8 are positioned at a corresponding angle α to the normal n to the plate surfaces 33, 34 and 35, 36, respectively.

By positioning the second plate-shaped body 32 in mirror-opposite relationship with respect to the first plate-shaped body 31, the ends 4 of the wirelike conductors 8 at the outer plate surface 33 formed by the first plate-shaped body 31 are aligned with the ends 4 of the wirelike conductors 8 at the outer plate surface 35 of the second plate-shaped body 32. The wirelike conductors 8 of the first and the second body 31, 32 are interconnected via the contact pads 42, 43 of the third plate-shaped body 39, which are in contact with the respective ends 6 of the conductors 8 in question.

This achieves that the ends 4 of the wirelike conductors 8 at the plate surface 33, which must be placed into contact with the terminals of a component to be measured or tested, for example for contacting the component, are aligned with the corresponding ends 4 of the wirelike conductors 8 at the plate surface 35, which is to be connected to measuring and testing means of a measuring apparatus, for example by means of an aligned connecting block (not shown). In this way the offset 7, see figure 2, is compensated, so that it is possible to use the contactor 30 with standard measuring and testing means arranged for being used with contact pins, without constructional alterations being required, whilst retaining all the advantages of the plate-shaped contactors as explained in the foregoing.

Preferably, the first and the second plate-shaped body 31 and 32 are identical to each other, which is not necessary, however.

The pattern of the contact pads 42, 43 of the third plate-shaped body 39 can be optimally geared to the terminals or terminal pads of a component to be measured or tested, a module or circuit, a wiring and/or a connecting block of measuring and testing means.

Figure 7 is a schematic sectional view along the line VII-VII of the contactor 30 in figure 6. Figure 6 is a sectional view along the line VI-VI in figure 7. Figure 7 shows that the contact pads 42 are arranged in a regular pattern in this embodiment of the invention, wherein the spacing between the contact pads 42, both in the transverse direction and in the longitudinal direction of the body 39, can be geared to the dimensions of electric components, wiring and modules or circuits, which are standardised in practice.

The contact pads 42, 43 may have a flat profile, such as an LGA profile as shown in figure 6, or be embossed on the plate body, for example having a semi-spherical shape, such as a BGA profile or a TFBGA profile.

In the left-hand bottom corner of figure 7 a view of the plate surface 36 of the body 32 is shown in a partially cut-away part thereof, in which the ends 6 of the conductors 8 can be distinguished. The dashed lines in figure 7 show a contact pad 43 and the manner in which the contact pad is contacted by respective ends 6 of the conductors 8 of the second body 32.

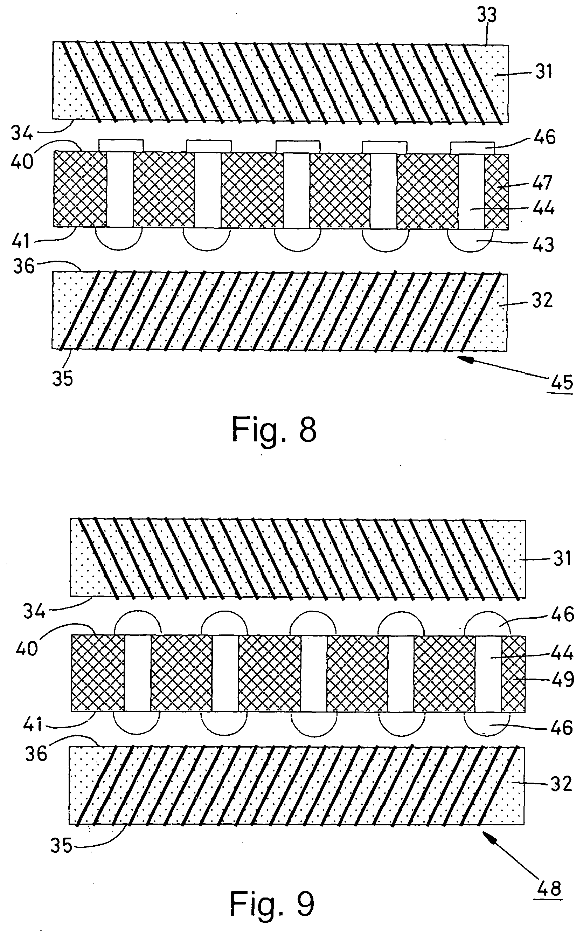

Figure 8 shows an embodiment of a contactor 45 according to the invention similar to the embodiment that is shown in figure 6, with a third plate-shaped body 47 whose contact pads 43 have a semi-spherical shape 46 and whose contact pads 42 have a flat shape.

Figure 9 shows an embodiment of a connector 48 with a third plate-shaped body 49, in which all the contact pads have a semi-spherical shape 46.

In a preferred embodiment of the invention, the contact pads and the conductors of the third body 39, 47, 49 are preferably made of gold or a gold-containing metal alloy. In a preferred embodiment, the plate-shaped third bodies 39, 47 and 49 are made of a ceramic material, which combines good mechanical and electrical properties.

In a practical embodiment of the invention, the third plate-shaped body has length and width dimensions that vary from a few mm to a few dozen mm, with a thickness in the order of about 0.5-1 mm and a spacing or pitch between the contact pads of, for example, 0.5-1.5 mm. The contact pads themselves may have a contact diameter of, for example, 300 µm. Different dimensions are possible, of course. The above values are merely given by way of orientation.

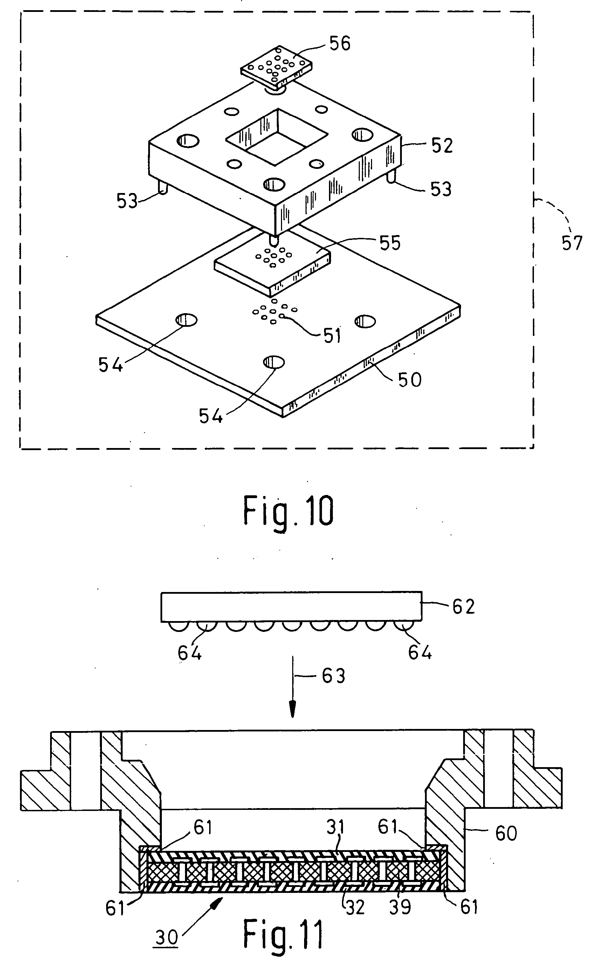

Figure 10 is a schematic, exploded view of a part of a measuring and testing apparatus provided with a contactor according to the invention.

Numeral 50 indicates a test board provided with a pattern of terminal pads 51 for connecting measuring and testing means of a measuring and testing apparatus. The measuring and testing apparatus is schematically indicated by means of dashed lines 57. A contactor 55 according to the invention is present in a frame 52 on the side of the test board 50, which frame is provided with guide pins 53 for mechanically guiding and aligning the frame in openings 54 in the test board 50. Present on the other side of the frame is the component to be measured or tested, such as an IC or a module or circuit 56.

In use, the contact pads on one side of the contactor 55 are in electrical contact with the terminal pads 51 of the test board 50 and on the opposite side the contact pads of the contactor 55 are in electrical contact with terminals of the component 56 to be measured or tested.

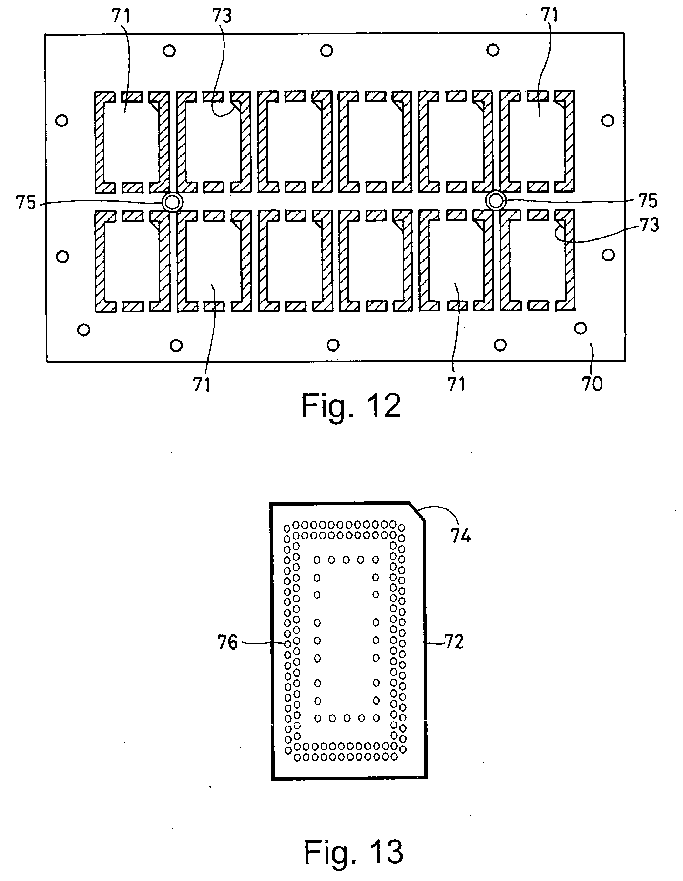

Figure 11 is a sectional view of the manner in which a contactor 38 as shown in figure 6 is mounted in a frame 60. Preferably, the contactor 38 is fixedly connected to the frame 60 by means of a heat-resistant, resilient, elastic glue 61. Note that in principle only the third plate-shaped body needs to be positioned and mounted in the frame, after which the first and the second plate-shaped body are provided on either side thereof, in accordance with the structure of the contactor according to the invention. Then the desired contact between the third plate-shaped body and the component and the connecting block can be effected via the first and the second plate-shaped body by exerting an external mechanical force in the direction of the normal to the plate surfaces. Numeral 62 indicates an electronic or electric component having BGA terminals 64 to be contacted by the contactor, with the arrow 63 indicating the direction in which the component 62 is placed into the frame 60.

Figure 12 shows a frame 70 provided with several receiving holes 71 for receiving a contactor according to the invention. Each contactor may be adapted to a component to be measured or tested by being provided with a suitable pattern of contact pads 76 on the third plate-shaped body thereof.

The receiving hole 71 and the contactor 72, i.e. at least the third plate-shaped body thereof, have bevelled corners 73 and 74, respectively, so as to enable a correct alignment of a contactor, such as the contactor 72 that is shown in top plan view in figure 13, in the frame 70, which bevelled corners furthermore prevent the contactor 72, which is provided with a pattern of contact pads especially adapted to match a respective component to be measured or tested, from being incorrectly received in a receiving hole 71, which might lead to incorrect measurement or test results.

The frame 70 is provided with alignment pins 75 with a view to ensure a correct alignment thereof in a measuring and testing apparatus. In a preferred embodiment of the invention, the frame is made of a glass fibre reinforced plastic, as known under the name of Torlon, for example, which is a pressure-moulded polymer material reinforced with 30% glass fibre.

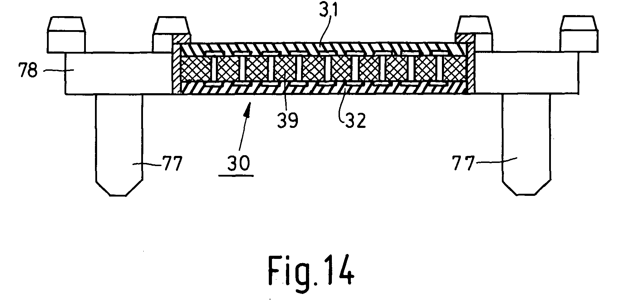

Figure 14 finally shows yet another embodiment of a frame 78 provided with a contactor 30 according to the invention intended for being mounted in a measuring and testing apparatus, in which the frame 78 is provided with alignment pins with a view to ensuring a correct and aligned centring thereof in a measuring and testing apparatus.

It will be understood that the contactor according to the invention can be used advantageously not only for replacing contactors in measuring and testing apparatuses for measuring and testing electric components and wiring, but in particular also in all those situations in which an aligned interconnection in the direction of the normal to the plate surfaces of the connector is required.

Many alterations and additions to the invention can be realised by those skilled in the art without departing from the scope of the invention as defined in the appended claims.

## Claims

1. A contactor comprising a first plate-shaped body of a compressible, electrically insulating material, with wirelike electrical conductors extending between opposed plate surfaces in said electrically insulating material at an angle to a normal to the plate surfaces, which conductors terminate in or extend some distance beyond the plate surfaces with their ends, **characterized by** a second plate-shaped body of a design similar to that of the first plate-shaped body, which first and second bodies are arranged adjacently to each other with one of their plate surfaces, such that the ends of the wirelike conductors at the plate surfaces that face towards each other are aligned in the direction of the normal to the plate surfaces as much as possible, and the ends of the wirelike conductors at the plate surfaces that face away from each other are aligned in the direction of the normal to the plate surfaces as much as possible, wherein a plate-shaped third body of an electrically insulating material is positioned between the adjacent plate surfaces of the first and the second body, which third body is provided with an identical pattern of electrically conductive contact pads on the opposed plate surfaces thereof, wherein corresponding contact pads on the opposed plate surfaces aligned in the direction of the normal to the plate surfaces are electrically interconnected.

2. A contactor according to claim 1, wherein the pattern of contact pads of the third body is geared to the pattern of electrical terminals of an electric component, or module or circuit, or an electrical wiring that is to be contacted via the contactor.

3. A contactor according to claim 1 or 2, wherein the contact pads of the third body are flat.

4. A contactor according to claim 1 or 2, wherein the contact pads of the third body are embossed on at least one plate surface.

5. A contactor according to claim 4, wherein the contact pads are semi-spherical in shape.

6. A contactor according to claim 5, wherein the contact pads have a so-called BGA-profile.

7. A contactor according to any of the claims 2-6, wherein the contact pads and the interconnections between the opposed contact pads of the third body are made of gold or a gold-containing metal alloy.

8. A contactor according to any of the claims 2-7, wherein the third body is made of a ceramic material.

9. A contactor according to any of the preceding claims, wherein the first and the second body are made of an elastomeric material.

10. A frame comprising a contactor according to any of the preceding claims, wherein the frame is provided with aligning means for aligning the contactor in the frame.

11. A frame according to claim 10, wherein the contactor and the frame are elongated in shape, and wherein said aligning means are made up of correspondingly bevelled corners of the frame and the contactor.

12. A frame according to claim 10 or 11, comprising a number of contactors for measuring and testing a number of electric components and wiring simultaneously.

13. A frame according to claim 10, 11 or 12, wherein the contactor is secured in the frame by means of an elastic glue.

14. A frame according to claim 10, 11, 12 or 13, which is made of a glass fibre reinforced plastic material.

15. An electrical measuring and testing apparatus for measuring and testing electric components and wiring , comprising a frame according to any of the claims 10-14.

16. A method for electrically contacting terminals of electric components and wiring by means of a contactor or a frame-mounted contactor as disclosed in any of the claims 1-14, said method being **characterized by** the steps of:
- selecting a contactor such that the pattern of contact pads of the contactor corresponds entirely or partially to a pattern of terminals of the component or wiring to be contacted,
- aligning said contactor and said component or wiring relative to each other in such a manner that the corresponding contact pads and terminals are aligned, and
- contacting a respective component or wiring in the aligned position by effecting an electrical contact between the contact pads and the terminals via the ends of the wirelike conductors at a plate surface of the contactor by exerting a mechanical pressure in the direction of the normal to the plate surfaces of the contactor.

17. A method according to claim 16, wherein electrical measuring and testing means are connected for electrically measuring or testing a component, by contacting ends of wirelike conductors at the plate surface of the contactor that faces away from the component or wiring to be measured or tested, via a pattern of terminals that corresponds entirely or partially to the terminals of a component to be measured or tested, and exerting a mechanical pressure in the direction of the normal to the plate surfaces.
